(19) **Europäisches Patentamt**
**European Patent Office**
**Office européen des brevets**

(11) **EP 3 579 397 A1**

(12) **EUROPEAN PATENT APPLICATION**
published in accordance with Art. 153(4) EPC

(43) Date of publication:
**11.12.2019 Bulletin 2019/50**

(21) Application number: **17895059.8**

(22) Date of filing: **13.11.2017**

(51) Int Cl.:
*H02N 2/18* (2006.01)   *H01L 41/053* (2006.01)
*H01L 41/113* (2006.01)

(86) International application number:
**PCT/JP2017/040699**

(87) International publication number:
**WO 2018/142714 (09.08.2018 Gazette 2018/32)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **31.01.2017 JP 2017015588**

(71) Applicant: **Panasonic Intellectual Property Management Co., Ltd.**
**Osaka-shi, Osaka 540-6207 (JP)**

(72) Inventors:
• **FUKUI, Takafumi**
  **Osaka 540-6207 (JP)**
• **KATSUMURA, Hidenori**
  **Osaka 540-6207 (JP)**
• **OKUMURA, Hidenori**
  **Osaka 540-6207 (JP)**

(74) Representative: **Grünecker Patent- und Rechtsanwälte**
**PartG mbB**
**Leopoldstraße 4**
**80802 München (DE)**

(54) **POWER GENERATION DEVICE**

(57)   A power generation device includes a holder 101 with a natural frequency of $f_A$, and two or more vibration energy harvesting elements 105 held by the holder 101 and having natural frequencies different from each other. Out of the vibration energy harvesting elements 105, one has the lowest natural frequency $f_{Bmin}$ satisfying the following Expression 1, and another one has the highest natural frequency $f_{Bmax}$ satisfying the following Expression 2:

$$f_{Bmin} \geq (0.925 - 2.5\,N/100)\,f_A \ldots \quad (1),$$

and

$$f_{Bmax} \leq (1.075 + 2.5\,N/100)\,f_A \ldots \quad (2),$$

where N is the number of the vibration energy harvesting elements 105.

EP 3 579 397 A1

# FIG. 1

**Description**

TECHNICAL FIELD

The present disclosure relates to a power generation device, particularly to a power generation device converting vibration energy into electrical energy.

BACKGROUND ART

With pressure applied in a specific direction, a piezoelectric element induces an electric polarization to generate a voltage. A power generation device using a piezoelectric element converts mechanical displacement to a voltage to generate electric power. Familiar mechanical displacement is, for example, vibration. If power is generated by vibration, there is no need to prepare any power supply to operate electronic devices.

An example method of generating electric power by vibration uses a vibration energy harvesting element including a piezoelectric element attached to a diaphragm. This method allows for efficient power generation, since large mechanical displacement is applied to the vibration energy harvesting element, when the natural frequency of the vibration energy harvesting element agrees with the frequency of input vibration.

In this method, however, small mechanical displacement is applied to the vibration energy harvesting element, when the natural frequency of the vibration energy harvesting element is different from the frequency of the input vibration. Thus, the power generation device using this method reduces the frequency range for efficient power generation.

The vibration of, for example, a machine or a structure varies depending on various conditions, and is not constant. It is thus difficult for a power generation device using this method to act as a power supply that stably supplies electric power.

A method considered to increase the frequency range for efficient power generation (see, for example, Patent Document 1) combines a plurality of vibration energy harvesting elements with different natural frequencies. In this method, however, the vibration energy harvesting elements operate merely separately. The power generation device using this method is less likely to efficiently generate electric power within a wide frequency range.

A method considered to efficiently generate electric power in a wide frequency range (see, for example, Patent Document 2) employs a two-degree-of-freedom vibration system including vibration energy harvesting elements attached to a holder with a natural frequency different from those of the vibration energy harvesting elements. The method combines two vibration systems to generate electric power within a frequency range several times as large as that of a single vibration energy harvesting element. The power generation device using this method thus can increase the total amount of power generation.

CITATION LIST

PATENT DOCUMENTS

Patent Document 1: Japanese Unexamined Patent Publication No. 2011-152004
Patent Document 2: International Publication No. WO 2015/087537

SUMMARY OF THE INVENTION

TECHNICAL PROBLEM

However, a further increase in the amount of power generation is demanded. In addition, a power generation device is desired, which stably generates electric power even at a variable frequency and whose amount of power generation is less dependent on the frequency. Installation of a plurality of power generation devices with different natural frequencies can increase the amount of power generation, and reduce the dependence of the amount of power generation on the frequency. However, the installation of a plurality of power generation devices causes a problem of an increasing installation area. If a plurality of vibration energy harvesting elements are attached to a common holder, not only a decrease in the installation area but also a decrease in the costs of a power generation device is expected.

The present inventors have found that the following problem arises; that is, if an increasing number of vibration energy harvesting elements are simply attached to a single holder to configure a power generation device, interference occurs among the vibration energy harvesting elements, thereby reducing the power generation efficiency and increasing the dependency of the amount of power generation on the frequency.

It is an object of the present disclosure to solve the problem found by the present inventors. A power generation device including a plurality of vibration energy harvesting elements attached to a single holder aims to achieve at least one of improved power generation efficiency and lower dependency of the amount of power generation on the frequency.

SOLUTION TO THE PROBLEM

A power generation device according to an aspect includes: a holder with a natural frequency of $f_A$; and two or more vibration energy harvesting elements held by the holder and having natural frequencies different from each other. One of the vibration energy harvesting elements has a lowest natural frequency $f_{Bmin}$ satisfying the following Expression 1, and another one of the vibration energy harvesting elements has a highest natural frequency $f_{Bmax}$ satisfying the following Expression 2:

$$f_{Bmin} \geq (0.925 - 2.5\ \mathrm{N}/100)\ f_A \ldots (1),$$

and

$$f_{Bmax} \leq (1.075 + 2.5\ \mathrm{N}/100)\ f_A \ldots (2),$$

where N is the number of the vibration energy harvesting elements.

ADVANTAGES OF THE INVENTION

The power generation device according to the present disclosure achieves at least one of improved power generation efficiency and lower dependency of the amount of power generation on the frequency.

BRIEF DESCRIPTION OF THE DRAWINGS

[FIG. 1] FIG. 1 is a cross-sectional view of a power generation device according to an embodiment.
[FIG. 2] FIG. 2 is a vibration model for explaining the power generation device according to the embodiment.
[FIG. 3] FIG. 3 is a cross-sectional view of a vibration energy harvesting element.
[FIG. 4] FIG. 4 is a cross-sectional view of a power generation device according to a first variation of the embodiment.
[FIG. 5] FIG. 5 is a cross-sectional view of a power generation device according to a second variation of the embodiment.
[FIG. 6A] FIG. 6A is a graph showing a measurement result of a device 1.
[FIG. 6B] FIG. 6B is a graph showing a measurement result of a device 2.
[FIG. 6C] FIG. 6C is a graph showing a measurement result of a device 3.
[FIG. 6D] FIG. 6D is a graph showing a measurement result of a device 4.
[FIG. 6E] FIG. 6E is a graph showing a measurement result of a device 5.
[FIG. 6F] FIG. 6F is a graph showing a measurement result of a device 6.
[FIG. 6G] FIG. 6G is a graph showing a measurement result of a device 7.
[FIG. 6H] FIG. 6H is a graph showing a measurement result of a device 8.
[FIG. 6I] FIG. 6I is a graph showing a measurement result of a device 9.
[FIG. 6J] FIG. 6J is a graph showing a measurement result of a device 10.
[FIG. 7A] FIG. 7A is a graph showing a measurement result of a device 11.
[FIG. 7B] FIG. 7B is a graph showing a measurement result of a device 12.
[FIG. 7C] FIG. 7C is a graph showing a measurement result of a device 13.
[FIG. 7D] FIG. 7D is a graph showing a measurement result of a device 14.
[FIG. 7E] FIG. 7E is a graph showing a measurement result of a device 15.
[FIG. 7F] FIG. 7F is a graph showing a measurement result of a device 16.
[FIG. 7G] FIG. 7G is a graph showing a measurement result of a device 17.
[FIG. 7H] FIG. 7H is a graph showing a measurement result of a device 18.
[FIG. 7I] FIG. 7I is a graph showing a measurement result of a device 19.
[FIG. 7J] FIG. 7J is a graph showing a measurement result of a device 20.

[FIG. 7K] FIG. 7K is a graph showing a measurement result of a device 21.

DESCRIPTION OF EMBODIMENT

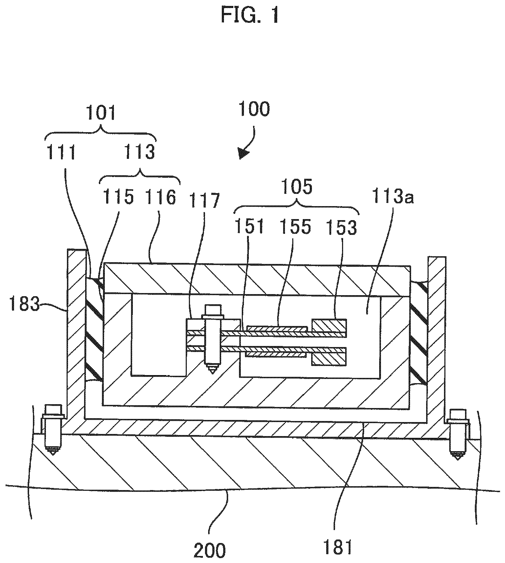

FIG. 1 illustrates a power generation device 100 according to an embodiment attached to a vibrating member 200. Although the direction in which the power generation device 100 is used is not limited, the following will be described on the assumption that the side closer to the vibrating member 200 is down and the side opposite to the vibrating member 200 is up.

As shown in FIG. 1, the power generation device 100 includes a holder 101 and N (N $\geq$ 2) vibration energy harvesting elements 105 attached to the holder 101. In FIG. 1, the holder 101 includes an elastic member 111 and a holder mass member 113, and constitutes a holder vibration system. Each of the vibration energy harvesting elements 105 includes a leaf spring 151, an element mass member 153, and a piezoelectric element 155, and constitutes an element vibration system. FIG. 1 shows an example where N is 2.

The vibrating member 200 includes all types of members that generate vibration. Examples of the vibrating member 200 include machines such as transportation machines, machine tools, household appliances, and components thereof. For example, motor vehicles, trains, aircrafts, refrigerators, and washing machines are included. Bodies, engines, motors, shafts, mufflers, bumpers, tires, compressors, and fans used these machines are also included. Further included are constructions such as buildings, roads and bridges, and associated structural members such as posts, walls and floors, and equipment such as elevators and ducts.

The holder mass member 113 is elastically connected to the vibrating member 200 by elastic members 111. The holder mass member 113 includes a case 115 with a housing space 113a for housing the vibration energy harvesting elements 105, and a lid 116.

In FIG. 1, in each of the vibration energy harvesting elements 105 housed in the case 115, the leaf spring has one end fixed to a fixing protrusion 117, which protrudes from a bottom of the case 115. The leaf spring 151 has an opposing end; namely a free end, to which an element mass member 153 is attached. Thus, each element mass member 153 has a cantilever structure; that is, the element mass member 153 is elastically connected to the holder mass member 113 by the leaf spring 151. Accordingly, the relative displacement of the element mass members 153 with respect to the holder mass member 113 is allowed by elastic deformation of the leaf springs 151 in the thickness direction. In this manner, the holder vibration system and the element vibration systems constitute a two-degree-of-freedom vibration system, and form, as a whole, a vibration system with N + 1 degrees of freedom.

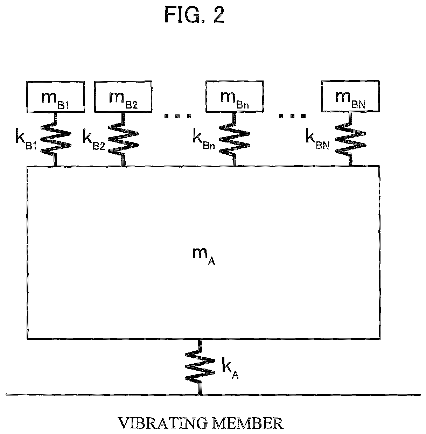

The power generation device including the N vibration energy harvesting elements serves as a multi-degree-of-freedom vibration system, which can be represented by a vibration model shown in FIG. 2. In FIG. 2, $m_A$ represents a mass of the holder mass member 113, $k_A$ represents a spring constant of the elastic member 111, and $x_A$ represents a displacement amount of the holder mass member 113. In addition, $m_{Bn}$ represents a mass of the element mass member 153 of the n-th vibration energy harvesting element, $k_{Bn}$ represents a spring constant of the leaf spring 151 of the n-th vibration energy harvesting element, and $x_{Bn}$ represents a displacement amount of the element mass member 153 of the n-th vibration energy harvesting element. $F_0 \sin 2\pi ft$ represents a vibration load input from the vibrating member 200 to the power generation device 100.

As represented by the following expression, a natural frequency $f_A$ of the single degree-of-freedom vibration system of the holder 101 alone is determined by $k_A$ of the elastic members 111 and the mass $m_A$ of the holder mass member 113. Note that $m_A$ is expressed as the mass of the holder mass member 113. Strictly, $m_A$ is the sum of the mass of the holder mass member 113 including the case 115 and the lid 116, and the mass of, for example, the power generation elements attached thereto.

[Math. 1]

$$f_A = \frac{1}{2\pi} \sqrt{\frac{k_A}{m_A}}$$

As represented by the following expression, a natural frequency $f_{Bn}$ of the single degree-of-freedom vibration system of the n-th vibration energy harvesting element 105 alone is determined by the elastic coefficient $k_{Bn}$ of the leaf spring 151 and the mass $m_{Bn}$ of the element mass member 153. Note that $m_{Bn}$ is expressed as the mass of the element mass member 153. Strictly, $m_{Bn}$ includes the masses of the leaf spring 151 and the piezoelectric element 155.

[Math. 2]

$$f_{Bn} = \frac{1}{2\pi}\sqrt{\frac{k_{Bn}}{m_{Bn}}}$$

In the power generation device according to the present embodiment, the plurality of vibration energy harvesting elements 105 fixed to the single holder 101 have natural frequencies different from each other. The lowest natural frequency $f_{Bmin}$ satisfies the following Expression 1, while the highest natural frequency $f_{Bmax}$ satisfies the following Expression 2.

$$f_{Bmin} \geq (0.925 - 2.5\ N/100)\ f_A \dots \quad (1)$$

$$f_{Bmax} \leq (1.075 + 2.5\ N/100)\ f_A \dots \quad (2)$$

Here, N is the number of the vibration energy harvesting elements 105 fixed to the single holder 101.
The natural frequencies of the plurality of vibration energy harvesting elements 105 attached to the holder 101 fall within such a range. This can improve the power generation efficiency and decrease the dependency of the amount of power generation on the frequency, as compared to the case of a single vibration energy harvesting element.
Further, within the range where $f_{Bmin}$ and $f_{Bmax}$ satisfy Expressions 1 and 2, respectively, the natural frequencies of the vibration energy harvesting elements 105 are adjusted to have a predetermined relationship, thereby providing various advantages. Assume that, for example, one of the vibration energy harvesting elements has an n-th lowest natural frequency $f_{Bn}$ and another one has an (n + 1)th lowest natural frequency $f_{Bn+1}$. Expressions 1 and 2 as well as the following Expression 3 may be satisfied.

$$f_{Bn} < 0.955 f_{Bn+1} \dots \quad (3)$$

In this manner, $f_{Bn}$ is set smaller than 0.955 times $f_{Bn+1}$. This can reduce the interference between the vibration energy harvesting elements to largely increase the amount of power generation. This case can provide a larger amount of power generation than the total amount of power generation of N power generation devices, each of which includes only one vibration energy harvesting element with a corresponding natural frequency and attached to a holder. This case can greatly improve the power generation efficiency.
The power generation device of the present embodiment can generate a larger total amount of power, if $f_{Bn}$ and $f_{Bn+1}$ satisfy Expression 3. However, assume that the amount of power generation is plotted with respect to the frequency of the input vibration in the power generation device of the present embodiment. Then, usually, the amount of power generation varies depending on the frequency, and the number of the vibration energy harvesting elements + 1 peaks appear. In view of reducing the dependency of the amount of power generation on the frequency to stably generate electric power, the differences may be small between the peaks and valleys. In view of reducing the differences between the peaks and valleys, the difference between $f_{Bn}$ and $f_{Bn+1}$ may be small to some extent. For example, $f_{Bn+1}$ may be 1.15 times or less of $f_{Bn}$ as represented by Expression 4.

$$f_{Bn+1} \leq 1.15\ f_{Bn} \dots \quad (4)$$

In view of further reducing the differences between the peaks and valleys , $f_{Bn+1}$ may be, for example, 1.07 times or less of $f_{Bn}$ ($f_{Bn+1} \leq 1.07\ f_{Bn}$) as represented by Expression 5. This can reduce the ratio between an amount $P_v$ of power generation at the lowest valley and an amount $P_t$ of power generation at the highest peak.

$$f_{Bn+1} \leq 1.07\ f_{Bn} \dots \quad (5)$$

Satisfaction of Expressions 1 and 2 as well as Expression 4 or 5 reduces the valleys representing largely decreasing amounts of power generation to allow for stable power generation. Further, satisfaction of Expression 3 in addition to Expressions 1 and 2 as well as Expression 4 or 5 increases the total amount of power generation to allow for stable power generation.

The mass $m_A$ of the holder mass member 113 may be determined based on the required natural frequency of the holder vibration system. Note that if the mass $m_A$ is 10% or more (mA $\geq$ 0.1 $\times$ M) of the equivalent mass M of the vibrating member 200, the holder mass member 113 has a sufficient influence on the vibration state of the vibrating member 200 to function as a dynamic damper. This can provide the advantage of cancelling the vibration and reducing the vibration of the vibrating member 200. Note that the power generation device 100 does not necessarily have to function as a damper such as a dynamic damper. In this case, the mass $m_A$ of the holder mass member 113 may be less than 10% of the equivalent mass M of the vibrating member 200.

Each element mass member 153 is for setting the natural frequency of the associated vibration energy harvesting element 105. The mass m of each element mass member 153 may be determined based on the required natural frequency of the vibration energy harvesting element 105. Note that $m_A \times X > m_{Btotal} \times Q$ may be satisfied as follows. The response magnification (resonance response magnification) X at the natural frequency of the holder 101 is set sufficiently smaller than the response magnification (resonance response magnification) Q at the natural frequency of the vibration energy harvesting element 105. The mass $m_A$ of the holder mass member 113 is set sufficiently larger than the total mass $m_{Btotal}$ of the element mass members 153. Such a setting provides a wider frequency bandwidth for generating greater power. This advantage is further increased by setting the mass $m_A$ of the holder mass member 113 five times or more of the total mass $m_{Btotal}$ of the element mass members 153.

Setting of the mass of each element mass member 153 smaller than that of the holder mass member 113 sufficiently reduces the spring constant of the associated leaf spring 151. This effectively causes the relative displacement of the holder mass member 113 with respect to the element mass member 153.

The leaf spring 151 of each vibration energy harvesting element 105 may be a metal member in a longitudinal plate made of, for example, spring steel or stainless steel for a spring.

The element mass member 153 of each vibration energy harvesting element 105 is a member in a rectangular block made of a material, such as iron, with high specific gravity. FIG. 1 shows an example where the element mass members 153 are attached to the ends of the respective leaf springs 151. However, the attachment positions of the element mass members 153 may be freely changed. A change in the positions of the element mass members 153 on the respective leaf springs 151 allows for adjustment of the natural frequencies of the vibration energy harvesting elements 105. Further, the element mass members 153 may be provided on the respective leaf springs 151 at the side opposite to the piezoelectric elements 155. The element mass members 153 may be attached to the respective leaf springs 151, for example, by an adhesive. Alternatively, the element mass members 153 may be fixed to the respective leaf springs 151, for example, by bolts to allow for adjustment of the attachment positions.

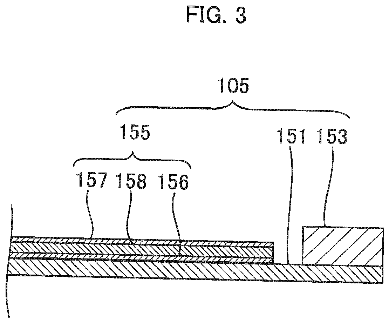

In each vibration energy harvesting element 105, the piezoelectric element 155 includes a lower electrode 156, an upper electrode 157, and a piezoelectric layer 158 interposed between the lower electrode 156 and the upper electrode 157, as shown in FIG. 3. In FIG. 3, the piezoelectric element 155 is formed only on one surface of the leaf spring 151, but may be formed on both surfaces.

The external force exerted from the vibrating member 200 onto the holder mass member 113 is transmitted to the element mass members 153. This causes relative displacement between the holder mass member 113 and the element mass members 153, and elastically deforms the leaf springs 151. Since the piezoelectric elements 155 are integral with the respective leaf springs 151, the vibration energy caused by the relative displacement between the holder mass member 113 and the element mass members 153 is input to the piezoelectric elements 155. This deforms the piezoelectric elements 155 together with the leaf springs 151, thereby generating voltages. Accordingly, the vibration power generation device of the present embodiment converts vibrational energy to electrical energy in accordance with the amount of relative displacement between the holder mass member 113 and the element mass members 153.

Electric power generated in each piezoelectric element 155 can be extracted from a lead connected to each of the lower electrode 156 and the upper electrode 157. The output of each piezoelectric element 155 can be rectified by a rectifier circuit and then connected in series or in parallel. The electric power generated in the piezoelectric element 155 can drive an electric circuit. The electric circuit is not particularly limited, but may be, for example, a DC/DC converter circuit, a power storage circuit, a sensor circuit, or a radio transmission/reception circuit.

Each piezoelectric layer 158 may be a film made of, for example, a ceramic material or a single crystal material. Examples of the material of the film may include lead zirconate titanate, aluminum nitride, lithium tantalate, and lithium niobate. The piezoelectric layer 158 may be a film with compressive stress applied thereto. This can largely deform the piezoelectric layer 158.

Each piezoelectric element 155 may be formed, for example, as follows. First, a paste layer of a silver-palladium alloy is screen-printed on a main surface of the leaf spring 151 made of a heat-resistant stainless-steel plate such as SUS430 containing a small amount of aluminum. Next, a paste layer of a piezoelectric material containing powder of a piezoelectric material composition is screen-printed on the paste layer of the silver-palladium alloy. A paste layer of a silver-palladium alloy is then screen-printed on the paste layer of the piezoelectric material to form an unsintered element. The unsintered element is then placed in a sintering sheath and sintered at 875°C for two hours. This sinters and densifies the paste layers of silver-palladium and the piezoelectric material. As a result, a sintered element is formed, which is integral with the leaf spring 151, and includes the lower electrode 156, the piezoelectric layer 158, and the upper electrode 157. Next, a voltage of 100 V is applied between the lower electrode 156 and the upper electrode 157 at 120°C for 30 minutes to polarize the piezoelectric layer 158.

Each leaf spring 151 may approximately have a width of, for example, 15 mm, a length of 30 mm, and a thickness of 0.1 mm. Each of the paste layers of silver-palladium and the piezoelectric material may approximately have a width of about 14.5 mm and a length of 24 mm. Each of the lower electrode 156 and the upper electrode 157 after the sintering may have a thickness of about 5 $\mu$m. The piezoelectric layer 158 after the sintering may have a thickness of about 25 $\mu$m.

The piezoelectric layer 158 may be made of, for example, $Pb_{1.015}Zr_{0.44}Ti_{0.46}(Zn_{1/3}Nb_{2/3})_{0.10}O_{3.015}$. This composition exhibits excellent piezoelectric properties, and the B site of lead zirconate titanate (PZT) is replaced with $Pb(Zn_{1/3}Nb_{2/3})O_3$ by 10 mol%. The Pb site ratio is 1.015 exceeding the stoichiometry. In this case, the paste of the piezoelectric material may be produced as follows. The raw materials are the powder of lead oxide (PbO), titanium dioxide ($TiO_2$), zirconium dioxide ($ZrO_2$), zinc oxide (ZnO), and niobium pentoxide ($Nb_2O_5$) with a purity of 99.9% or more. With the use of these raw materials, the powder of a piezoelectric material composition with a molar ratio represented by the composition formula (1) is prepared by a solid phase method. In order to sinter the piezoelectric layer at a temperature of 900°C or below, the powder has a particle size smaller than 0.5 $\mu$m.

Next, an organic vehicle containing an organic binder and a solvent is prepared. The organic binder may be made of at least one selected from, for example, an ethyl cellulose resin, an acrylic resin, a butyral resin. The solvent may be made of, for example, $\alpha$-terpineol or butyl carbitol. The mixing ratio of the organic binder to the solvent may be, for example, 2:8. The organic vehicle and the powder of the piezoelectric material composition are mixed and kneaded together with an appropriate amount of a phosphoric ester-based dispersant. Accordingly, the paste of the piezoelectric material is obtained. The mixing ratio of the organic vehicle to the piezoelectric material composition may be 20:80 by weight. For the kneading, for example, a three-ball mill may be used.

The silver-palladium paste may be a paste containing silver-palladium alloy particles of, for example, 90% of silver and 10% of palladium. The silver-palladium alloy particles may have a particle size of about 0.9 $\mu$m.

To the surface of the piezoelectric layer 158 of the piezoelectric element 155 obtained in this manner, a compressive stress of, for example, about 450 MPa is applied. The reason is found in the difference in the average thermal expansion coefficient from the room temperature to the firing temperature of 900°C. The PZT-based piezoelectric material has an average of about 5 ppm/K, while the heat-resistant stainless-steel plate has a significantly large average of 12 ppm/K. The residual stress on the surface of the piezoelectric layer 158 may be obtained as follows. The upper electrode 157 of the piezoelectric element 155 is removed by polishing to expose the piezoelectric layer 158. Then, the interval of the crystal lattice is measured on the exposed surface of the piezoelectric layer 158 by X-ray diffraction. To measure the residual stress, for example, the peak derived from the plane index (111) may be used, where the diffraction angle $2\theta$ appears around 38°.

In FIG. 1, the case 115 houses two vibration energy harvesting elements 105. Each of the vibration energy harvesting elements 105 is fixed so that the vibration direction agrees with that of the holder vibration system. Note that the phase "the vibration direction agrees" means that the main vibration direction agrees with that of the holder vibration system. The phase of the vibration is not discussed. The "main vibration direction" is referred to as the direction with the maximum displacement. The term "agree" includes the displacement within $\pm30°$, $\pm20°$ in one preferred embodiment, and $\pm10°$ in one more preferred embodiment.

In this embodiment, each vibration energy harvesting element 105 is fixed to the fixing protrusion 117 that protrudes from the bottom of the case 115. This can reduce the difference in the vertical position of the center of gravity between the holder mass member 113 and the element mass member 153. Further, the support position of the leaf spring 151 becomes closer to the center of the case 115 to reduce the difference in the horizontal position of the center of gravity between the element mass member 153 and the holder mass member 113. Accordingly, the vertical vibration of the holder mass member 113 is directly and efficiently transmitted to the leaf spring 151 to cause, in the leaf spring 151, bending deformation effective for power generation. On the other hand, there is vibration which inhibits bending deformation of the leaf spring 151, such as vibration displacement and rotational displacement, with the maximum vibration amplitude at the outer edge of the case 115. Such vibration is less transmitted to the vibration energy harvesting element 105, which improves the power generation efficiency.

FIG. 1 shows an example where the plurality of vibration energy harvesting elements 105 are vertically arranged in the single fixing protrusion 117. However, a plurality of fixing protrusions 117 may be provided in accordance with the sizes of the vibration energy harvesting elements 105 and the holder mass member 113 to horizontally arrange the vibration energy harvesting elements 105. In this case, the plurality of vibration energy harvesting elements 105 may be vertically arranged in each of the fixing protrusions 117. For example, assume that the case 115 constituting the holder mass member 113 approximately has a width of 90 mm, a length of 60 mm, and a height of 30 mm. The case 115 is capable of housing four vibration energy harvesting elements 105, each of which approximately has a width of 15 mm, a length of 30 mm, and a thickness of 0.1 mm.

In FIG. 1, the holder mass member 113 is fixed to the vibrating member 200 via a connecting member 181. The connecting member 181 has walls 183 facing the outer peripheral side surfaces of the holder mass member 113.Between each pair of the outer peripheral side surface of the holder mass member 113 and the wall 183, the elastic member 111 is disposed. In FIG. 1, the walls 183 of the connecting member 181 face the two outer peripheral side surfaces of the holder mass member 113. Alternatively, the walls 183 may face three or four surfaces. The elastic members 111 may be provided on all the outer peripheral side surfaces facing the walls 183. The elastic member(s) 111 may be provided over the entire circumference, or may be provided at several positions on the circumference.

In this manner, the outer peripheral side surfaces of the holder mass member 113 are held by the elastic members 111. The elastic members 111 are mainly subjected to shear deformation in the direction in which the vibration is input from the vibrating member 200. This easily provides low dynamic spring characteristics, and improves the degree of freedom in tuning.

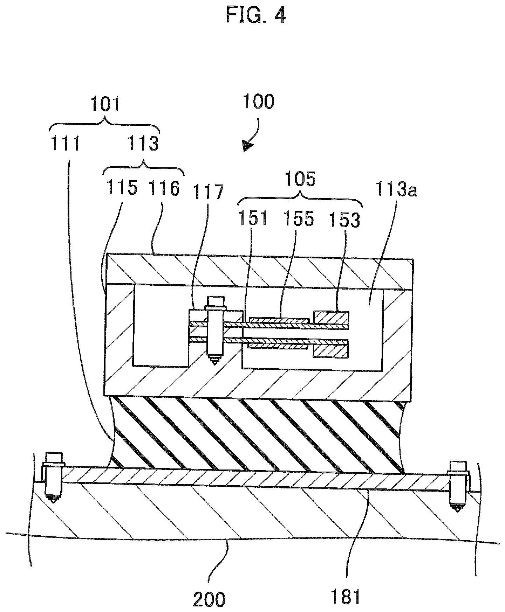

The shapes and arrangement of the holder mass members 113 and the elastic members 111 are not limited thereto, as long as allowing for efficient input of vibration from the vibrating member 200. For example, as in a first variation shown in FIG. 4, the elastic member 111 may be disposed on the bottom of the holder mass member 113.

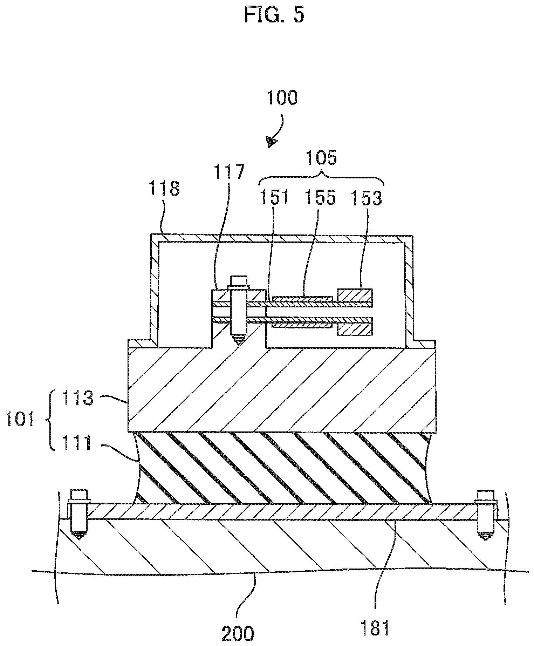

Further, the holder mass member 113 serves as the case 115 with the housing space 113a to encapsulate vibration energy harvesting elements 105. This facilitates reduction in degradation of the vibration energy harvesting elements. Note, for example, that the shape of the holder mass member 113 and the attachment position of the leaf springs 151 may be freely designed. For example, as in a second variation shown in FIG. 5, the vibration energy harvesting elements 105 may be attached above the holder mass member 113. In this case, the cover 118 covering the vibration energy harvesting elements 105 may be provided as necessary. In the case where the vibration energy harvesting elements 105 are attached above the holder mass member 113, the elastic member 111 may also be provided on the outer peripheral side surfaces of the holder mass member 113.

Although not particularly limited, the holder mass member 113 may be made of a material with a higher specific gravity. For example, iron may be used. The elastic member(s) 111 may be of any type, as long as being capable of elastically connecting the holder mass member 113 to the vibrating member 200. For example, a rubber elastic body in a rectangular block may be used. Examples of the rubber elastic body may include natural rubber, synthetic rubber or blend rubber of natural rubber and synthetic rubber. The synthetic rubber may be any one of styrene-butadiene rubber, butadiene rubber, isoprene rubber, chloroprene rubber, isobutylene-isoprene rubber, chlorinated isobutylene-isoprene rubber, acrylonitrile-butadiene rubber, hydrogenated acrylonitrile-butadiene rubber, ethylene-propylene-diene rubber, ethylene-propylene rubber, acrylic rubber, and silicone rubber. Alternatively, the elastic member(s) 111 is/are not limited to the rubber elastic body/bodies, and may be made of a metal spring such as a coil spring, a leaf spring, or a rod spring.

The elastic member(s) 111 is/are not necessarily a dedicated member(s), and may be a part of the structure of the vibrating member 200. For example, if the vibration member 200 is a vehicle, an elastic part of a damping dynamic damper provided in the vehicle may be used as the elastic member 111.

In this embodiment, an example has been described where the power generation device 100 is attached to the vibrating member 200 via the connecting member 181. The connecting member 181 may be provided as necessary, and the power generation device 100 may be directly attached to the vibrating member 200. The shape of the connecting member 181 may be freely designed in accordance with the shapes of the power generation device 100 and the vibrating member 200. An example has been described where the connection member 181 and the vibrating member 200 are fixed by bolts. The configuration is not limited thereto, and these members may be fixed, for example, by an adhesive or welding.

In this embodiment, an example has been described where all the vibration energy harvesting elements 105 attached to the holder 101 satisfy the relationships of predetermined natural frequencies. However, assume that three or more vibration energy harvesting elements 105 are attached to the holder 101. If at least two vibration energy harvesting elements 105 satisfy the relationships of the predetermined natural frequencies, one or more vibration energy harvesting elements 105 may satisfy none of the relationships of the predetermined natural frequencies.

The power generation device of the present embodiment requires only a small space for attachment. In addition, the power generation device achieves one or both of a larger amount of power generation, and lower dependence of the amount of power generation on the frequency. The application of the power generation device of the present embodiment is not particularly limited. The power generation device may be used, for example, for power supplies of a sensor for monitoring the state of a device generating vibration, a guide light turned on when someone walks by, and a sensor for monitoring vibration caused movement of, for example, a person, a vehicle, and a device. The power generation device may also be used as a sensor.

[Examples]

The present disclosure will now be described in more detail with reference to the following examples. The following examples are illustrative and are not intended to limit the present disclosure.

<Measurement of Power Generation Characteristics>

Vibration power generation devices, each of which includes a combination of a holder and a plurality of vibration energy harvesting elements, are provided with vibration using a vibration generator to generate electric power. The generated power was measured by detecting across voltages $Vrms_n$ output leads of vibration energy harvesting elements. Generated power $P_n$ of the vibration energy harvesting elements was calculated by $Vrms_n^2/R$, where R is a value of a resistor connected between the leads, and set to 100 k$\Omega$. The sum of the generated power $P_n$ of the vibration energy harvesting elements was referred to as the generated power P of the power generation devices. The frequencies were varied within a range from 80 Hz to 150 Hz to obtain the generated power P at respective frequencies. The integrated value was referred to as the total generated power $P_{total}$. The acceleration of the vibration applied by the vibration generator was 0.1 G.

(Example 1)

Power generators were used, each of which includes two vibration energy harvesting elements attached to a holder. The holder had a natural frequency $f_A$ of 111.14 Hz. One of the vibration energy harvesting elements had a fixed natural frequency of 114 Hz. The other vibration energy harvesting element had a predetermined natural frequency within a range from 90 Hz to 130 Hz. With respect to the power generation devices, the dependency of the generated power on the frequency and the total generated power $P_{total}$ were evaluated. In addition, comparative power generation devices equipped with vibration energy harvesting elements with predetermined natural frequencies were prepared, and the total generated power was measured. The sum $P_{1+2}$ of the generated power was obtained so that the vibration energy harvesting elements had the same combination of frequencies as those of the power generation devices according to the present example. Then, the difference between $P_{total}$ and $P_{1+2}$ was evaluated. As to the generated power, a highest peak value $P_t$ and a lowest valley value $P_v$ between the plurality of peaks were evaluated. As an index to indicate the expansion of the frequency range, a frequency range $\Delta f_{100}$ was obtained, in which a power of 100 $\mu$W or more was provided, using 100 $\mu$W as a reference.

Device 1 with a natural frequency of 90 Hz had $P_{total}$ of 5013 $\mu$W. The difference between $P_{total}$ and $P_{1+2}$ was 1468 $\mu$W, and $\Delta f_{100}$ was 18.6 Hz.

Device 2 with a natural frequency of 94 Hz had $P_{total}$ of 5236 $\mu$W. The difference between $P_{total}$ and $P_{1+2}$ was 974 $\mu$W, and $\Delta f_{100}$ was 20.1 Hz.

Device 3 with a natural frequency of 98 Hz had $P_{total}$ of 5727 $\mu$W. The difference between $P_{total}$ and $P_{1+2}$ was 1221 $\mu$W, and $\Delta f_{100}$ was 25.6 Hz.

Device 4 with a natural frequency of 102 Hz had $P_{total}$ of 5829 $\mu$W. The difference between $P_{total}$ and $P_{1+2}$ was 1614 $\mu$W, and $\Delta f_{100}$ was 22.8 Hz.

Device 5 with a natural frequency of 106 Hz had $P_{total}$ of 5830 $\mu$W. The difference between $P_{total}$ and $P_{1+2}$ was 1322 $\mu$W, and $\Delta f_{100}$ was 20.6 Hz.

Device 6 with a natural frequency of 110 Hz had $P_{total}$ of 3246 $\mu$W. The difference between $P_{total}$ and $P_{1+2}$ was -1723 $\mu$W, and $\Delta f_{100}$ was 17.3 Hz.

Device 7 with a natural frequency of 118 Hz had $P_{total}$ of 4278 $\mu$W. The difference between $P_{total}$ and $P_{1+2}$ was -879 $\mu$W, and $\Delta f_{100}$ was 20.0 Hz.

Device 8 with a natural frequency of 122 Hz had $P_{total}$ of 5754 $\mu$W. The difference between $P_{total}$ and $P_{1+2}$ was 1185 $\mu$W, and $\Delta f_{100}$ was 23.2 Hz.

Device 9 with a natural frequency of 126 Hz had $P_{total}$ of 5012 $\mu$W. The difference between $P_{total}$ and $P_{1+2}$ was 815 $\mu$W, and $\Delta f_{100}$ was 23.5 Hz.

Device 10 with a natural frequency of 130 Hz had $P_{total}$ of 4471 $\mu$W. The difference between $P_{total}$ and $P_{1+2}$ was 655 $\mu$W, and $\Delta f_{100}$ was 18.3 Hz.

[Table 1]

| Device | Natural Frequency [Hz] | | | $P_{total}$ ($\mu$W) | $P_{total}$ - $P_{1+2}$ ($\mu$W) | $P_t$ ($\mu$W) | $P_v$ ($\mu$W) | $P_t/P_v$ (%) | $\Delta f_{100}$ (Hz) |
|---|---|---|---|---|---|---|---|---|---|
| | Holder | Vibration Power Generation Element | | | | | | | |
| | | 1 | 2 | | | | | | |
| 1 | 111.14 | 114 | 90 | 5013 | 1468 | 288 | 23 | 8 | 18.6 |

(continued)

| Device | Natural Frequency [Hz] | | | $P_{total}$ ($\mu$W) | $P_{total} - P_{1+2}$ ($\mu$W) | $P_t$ ($\mu$W) | $P_v$ ($\mu$W) | $P_t/P_v$ (%) | $\Delta f_{100}$ (Hz) |
|---|---|---|---|---|---|---|---|---|---|
| | Holder | Vibration Power Generation Element | | | | | | | |
| | | 1 | 2 | | | | | | |
| 2 | 111.14 | 114 | 94 | 5236 | 974 | 298 | 49 | 16 | 20.1 |
| 3 | 111.14 | 114 | 98 | 5727 | 1221 | 351 | 97 | 28 | 25.6 |
| 4 | 111.14 | 114 | 102 | 5829 | 1614 | 410 | 162 | 40 | 22.8 |
| 5 | 111.14 | 114 | 106 | 5830 | 1322 | 429 | 188 | 44 | 20.6 |
| 6 | 111.14 | 114 | 110 | 3246 | -1723 | 319 | 219 | 69 | 17.3 |
| 7 | 111.14 | 114 | 118 | 4278 | -879 | 289 | 145 | 50 | 20.0 |
| 8 | 111.14 | 114 | 122 | 5754 | 1185 | 319 | 152 | 48 | 23.2 |
| 9 | 111.14 | 114 | 126 | 5012 | 815 | 301 | 103 | 34 | 23.5 |
| 10 | 111.14 | 114 | 130 | 4471 | 655 | 271 | 45 | 17 | 18.3 |

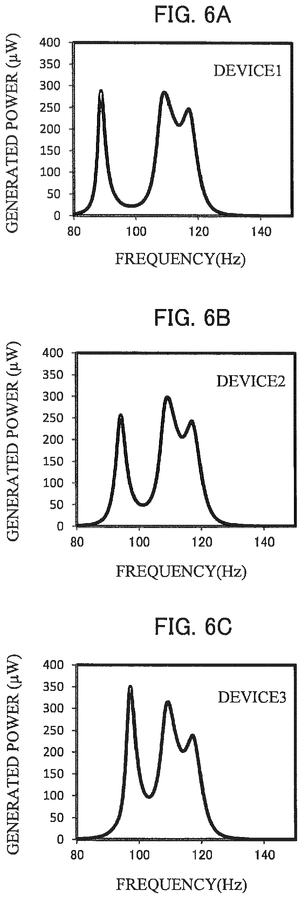

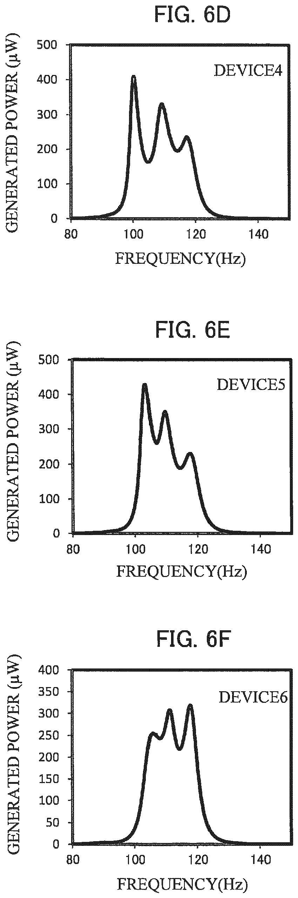

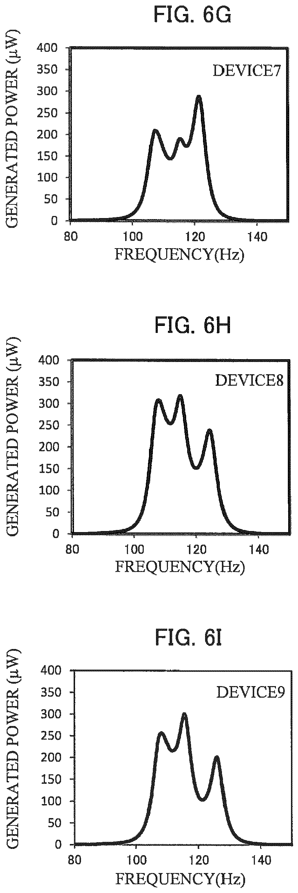

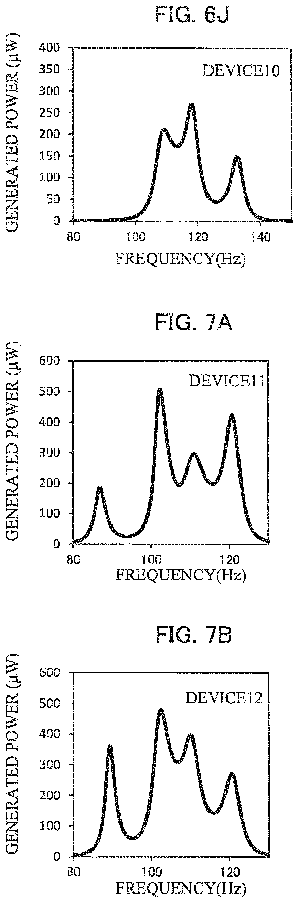

Table 1 collectively shows evaluation results of Devices 1 to 10. FIGS. 6A to 6J show the dependence of the power generated by Devices 1 to 10 on the vibration. Devices 3 to 8, in which the lowest natural frequency $f_{min}$ satisfies Expression 1 and the highest natural frequency $f_{max}$ satisfies Expression 2, are free from a significantly low valley between peaks, and thus stably generate electric power.

Among the devices, in which $f_{min}$ and fmax satisfy the conditions of Expressions 1 and 2, respectively, Devices 4 to 8 include two vibration energy harvesting elements with natural frequencies satisfying Expression 4. Each of these devices has a Pv/Pt ratio of 40% or higher, and thus more stably generates electric power. In addition, Devices 6 to 8, which satisfy Expression 5, have a $P_v/P_t$ ratio of 45% or higher, and thus further more stably generate electric power.

Among the devices, in which $f_{min}$ and $f_{max}$ satisfy the conditions of Expressions 1 and 2, respectively, Devices 3 to 5 and 8 include two vibration energy harvesting elements with natural frequencies satisfying Expression 3. The total power generated is increased and the power generation efficiency is improved.

(Example 2)

Power generators are used, each of which includes three vibration energy harvesting elements attached to a holder. The holder had a natural frequency $f_A$ of 105.8 Hz. Two of the vibration energy harvesting elements had natural frequencies of 107.1 Hz and 119.3 Hz. The other one of the vibration energy harvesting elements had a predetermined natural frequency within a range from 89 Hz to 122.7 Hz. As to the power generation devices, the dependency of the generated power on the frequency and the total generated power $P_{total}$ were evaluated. As to the generated power, a highest peak value Pt a lowest valley value $P_v$ between the plurality of peaks were evaluated. As an index to indicate the expansion of the frequency range, a frequency range $\Delta f_{100}$ was obtained, in which a power of 100 $\mu$W or more was provided, using 100 $\mu$W as a reference.

Device 11 with a natural frequency of 89 Hz had $P_{total}$ of 8166 $\mu$W and $\Delta f_{100}$ of 25.0 Hz.
Device 12 with a natural frequency of 91.1 Hz had $P_{total}$ of 8798 $\mu$W and $\Delta f_{100}$ of 25.2 Hz.
Device 13 with a natural frequency of 92.6 Hz had $P_{total}$ of 8987 $\mu$W and $\Delta f_{100}$ of 31.3 Hz.
Device 14 with a natural frequency of 94.4 Hz had $P_{total}$ of 9094 $\mu$W and $\Delta f_{100}$ of 33.4 Hz.
Device 15 with a natural frequency of 101.5 Hz had $P_{total}$ of 9164 $\mu$W and $\Delta f_{100}$ of 28.9 Hz.
Device 16 with a natural frequency of 103.4 Hz had $P_{total}$ of 8723 $\mu$W and $\Delta f_{100}$ of 28.3 Hz.
Device 17 with a natural frequency of 111.7 Hz had $P_{total}$ of 8073 $\mu$W and $\Delta f_{100}$ of 26.9 Hz.
Device 18 with a natural frequency of 111.8 Hz had $P_{total}$ of 8395 $\mu$W and $\Delta f_{100}$ of 27.3 Hz.
Device 19 with a natural frequency of 113.4 Hz had $P_{total}$ of 8709 $\mu$W and $\Delta f_{100}$ of 26.3 Hz.
Device 20 with a natural frequency of 115.5 Hz had $P_{total}$ of 8207 $\mu$W and $\Delta f_{100}$ of 27.6 Hz.
Device 21 with a natural frequency of 122.7 Hz had $P_{total}$ of 7513 $\mu$W and $\Delta f_{100}$ of 25.7 Hz.

[Table 2]

| Device | Natural Frequency [Hz] | | | | $P_{total}$ (μW) | $P_t$ (μW) | $P_v$ (μW) | $P_t/P_v$ (%) | $\Delta f_{100}$ (Hz) |
|---|---|---|---|---|---|---|---|---|---|
| | Holder | Vibration Power Generation Element | | | | | | | |
| | | 1 | 2 | 3 | | | | | |
| 11 | 105.8 | 107.1 | 119.3 | 89 | 8166 | 508 | 26 | 5 | 25.0 |
| 12 | 105.8 | 107.1 | 119.3 | 91.1 | 8798 | 479 | 60 | 13 | 25.2 |
| 13 | 105.8 | 107.1 | 119.3 | 92.6 | 8987 | 490 | 78 | 16 | 31.3 |
| 14 | 105.8 | 107.1 | 119.3 | 94.4 | 9094 | 494 | 114 | 23 | 33.4 |
| 15 | 105.8 | 107.1 | 119.3 | 101.5 | 9164 | 529 | 153 | 29 | 28.9 |
| 16 | 105.8 | 107.1 | 119.3 | 103.4 | 8723 | 521 | 162 | 31 | 28.3 |
| 17 | 105.8 | 107.1 | 119.3 | 111.7 | 8073 | 398 | 201 | 51 | 26.9 |
| 18 | 105.8 | 107.1 | 119.3 | 111.8 | 8395 | 423 | 196 | 46 | 27.3 |
| 19 | 105.8 | 107.1 | 119.3 | 113.4 | 8709 | 509 | 209 | 41 | 26.3 |
| 20 | 105.8 | 107.1 | 119.3 | 115.5 | 8207 | 439 | 174 | 40 | 27.6 |
| 21 | 105.8 | 107.1 | 119.3 | 122.7 | 7513 | 446 | 90 | 20 | 25.7 |

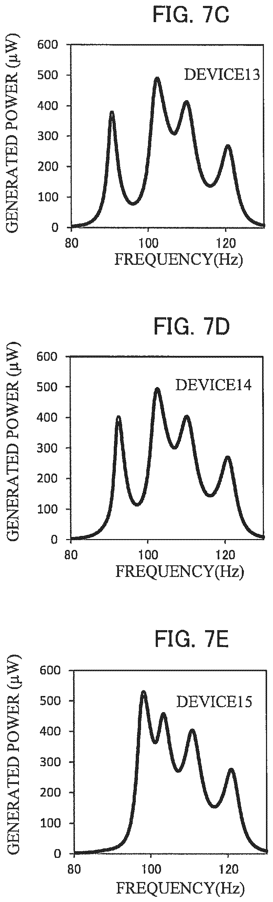

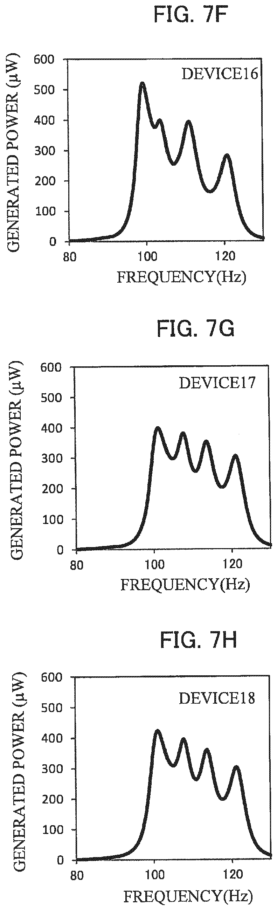

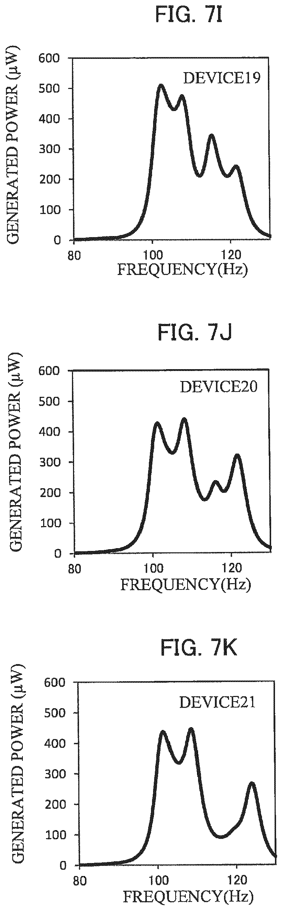

Table 2 collectively shows evaluation results of Devices 11 to 21. FIGS. 7A to 7K show the dependence of the power generated by Devices 11 to 21 on the vibration. Devices 12 to 20, in which the lowest natural frequency $f_{min}$ satisfies Expression 1 and the highest natural frequency $f_{max}$ satisfies Expression 2, are free from a significantly low valley between peaks, and thus stably generate electric power.

Among the devices, in which $f_{min}$ and $f_{max}$ satisfy the conditions of Expressions 1 and 2, respectively, Devices 14 to 20 include three vibration energy harvesting elements with natural frequencies satisfying Expression 4. Each of these devices has a $P_v/P_t$ ratio of 20% or higher, and thus more stably generates electric power. In addition, Devices 15 to 20, which satisfy Expression 5, a have $P_v/P_t$ ratio of 25% or higher, and thus further more stably generate electric power.

Among the devices, in which $f_{min}$ and $f_{max}$ satisfy the conditions of Expressions 1 and 2, respectively, Devices 12 to 15 and 19 include three vibration energy harvesting elements with natural frequencies satisfying Expression 3. The total power generated is increased and the power generation efficiency is improved.

INDUSTRIAL APPLICABILITY

The power generation device according to the present disclosure achieves at least one of improved power generation efficiency and lower dependency of the amount of power generation on the frequency. The power generation device is thus useful as, for example, a power generation device that generates power by vibration.

DESCRIPTION OF REFERENCE CHARACTERS

- 100 Power Generation Device
- 101 Holder
- 105 Vibration Energy Harvesting Element
- 111 Elastic Member
- 111 Plane Index
- 113 Holder Mass Member
- 113a Housing Space
- 115 Case
- 116 Lid
- 117 Fixing Protrusion

| 118 | Cover |
|-----|-------|
| 151 | Leaf Spring |
| 153 | Element Mass Member |
| 155 | Piezoelectric Element |
| 156 | Lower Electrode |
| 157 | Upper Electrode |
| 158 | Piezoelectric Layer |
| 181 | Connecting Member |
| 183 | Wall |
| 200 | Vibrating Member |

**Claims**

1. A power generation device, comprising:

   a support member with a natural frequency of $f_A$; and
   two or more vibration energy harvesting elements supported by the support member and having natural frequencies different from each other, wherein
   one of the vibration energy harvesting elements has a lowest natural frequency $f_{Bmin}$ satisfying the following Expression 1, and another one of the vibration energy harvesting elements has a highest natural frequency $f_{Bmax}$ satisfying the following Expression 2:

$$f_{Bmin} \geq (0.925 - 2.5\,N/100)\,f_A \ldots (1),$$

   and

$$f_{Bmax} \leq (1.075 + 2.5\,N/100)\,f_A \ldots (2),$$

   where N is the number of the vibration energy harvesting elements.

2. The power generation device according to claim 1, wherein
   two of the vibration energy harvesting elements have n-th and (n + 1)th lowest natural frequencies $f_{Bn}$ and $f_{Bn+1}$ satisfying the following Expression 3:

$$f_{Bn} < 0.955 f_{Bn+1} \ldots (3).$$

3. The power generation device according to claim 1 or 2, wherein two of the vibration energy harvesting elements have n-th and (n + 1)th lowest natural frequencies $f_{Bn}$ and $f_{Bn+1}$ satisfying the following Expression 4:

$$f_{Bn+1} \leq 1.15 f_{Bn} \ldots (4).$$

4. The power generation device according to any one of claims 1 to 3, wherein each of the vibration energy harvesting elements includes a leaf spring integral with a piezoelectric element, and a vibration element mass member attached to the leaf spring.

5. The power generation device according to claim 4, wherein
   the piezoelectric element includes a piezoelectric film provided on a surface of the leaf spring, and
   compressive stress is applied to the piezoelectric film.

6. The power generation device according to claim 4 or 5, wherein
   one end of the leaf spring is fixed to the holder, and another end of the leaf spring is a free end.

**7.** The power generation device according to any one of claims 4 to 6, wherein
a position of the vibration element mass member in the leaf spring is adjustable.

**8.** The power generation device according to any one of claims 1 to 7, wherein
the holder includes a holder mass member,
the holder mass member has a housing space housing the vibration energy harvesting elements, and
the holder mass member has a center of gravity set in the housing space.

FIG. 1

FIG. 2

VIBRATING MEMBER

FIG. 3

105

155

151 153

157 158 156

FIG. 4

FIG. 5

## FIG. 6A

## FIG. 6B

## FIG. 6C

## FIG. 6D

## FIG. 6E

## FIG. 6F

## FIG. 6G

## FIG. 6H

## FIG. 6I

FIG. 6J

FIG. 7A

FIG. 7B

## FIG. 7C

## FIG. 7D

## FIG. 7E

FIG. 7F

FIG. 7G

FIG. 7H

## FIG. 7I

## FIG. 7J

## FIG. 7K

## INTERNATIONAL SEARCH REPORT

| International application No. |
| --- |
| PCT/JP2017/040699 |

**A.  CLASSIFICATION OF SUBJECT MATTER**
Int.Cl. H02N2/18(2006.01)i, H01L41/053(2006.01)i, H01L41/113(2006.01)i

According to International Patent Classification (IPC) or to both national classification and IPC

**B.   FIELDS SEARCHED**

Minimum documentation searched (classification system followed by classification symbols)
Int.Cl. H02N2/18, H01L41/053, H01L41/113

| Documentation searched other than minimum documentation to the extent that such documents are included in the fields searched | |
| --- | --- |
| Published examined utility model applications of Japan | 1922–1996 |
| Published unexamined utility model applications of Japan | 1971–2018 |
| Registered utility model specifications of Japan | 1996–2018 |
| Published registered utility model applications of Japan | 1994–2018 |

Electronic data base consulted during the international search (name of data base and, where practicable, search terms used)

**C.   DOCUMENTS CONSIDERED TO BE RELEVANT**

| Category* | Citation of document, with indication, where appropriate, of the relevant passages | Relevant to claim No. |
| --- | --- | --- |
| A | JP 2011-152004 A (TOYOTA CENTRAL RESEARCH AND DEVELOPMENT LABORATORIES, INC.) 04 August 2011, paragraph [0029], fig. 4-6 (Family: none) | 1-8 |
| A | JP 5761336 B2 (MURATA MFG. CO., LTD.) 12 August 2015, paragraphs [0013], [0017]-[0019], fig. 1-2 & US 2013/0320807 A1, paragraphs [0017], [0034]-[0035], fig. 1-2 & EP 2662971 A1 & CN 103460592 A | 1-8 |
| A | JP 2016-77037 A (TOYO TIRE AND RUBBER CO., LTD.) 12 May 2016, paragraphs [0034]-[0040], fig. 5 (Family: none) | 1-8 |

☐  Further documents are listed in the continuation of Box C.         ☐  See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 17 January 2018 (17.01.2018) | 30 January 2018 (30.01.2018) |

| Name and mailing address of the ISA/ | Authorized officer |
| --- | --- |
| Japan Patent Office 3-4-3, Kasumigaseki, Chiyoda-ku, Tokyo 100-8915, Japan | |
| | Telephone No. |

Form PCT/ISA/210 (second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011152004 A
- WO 2015087537 A